# EUROPEAN PATENT APPLICATION

(11) **EP 1 653 287 A1**
(43) Date of publication of application: **03.05.2006**
(21) Application number: 04745608.2
(22) Date of filing: 04.06.2004
(51) Int. Cl.: G03F 7/40, H01L 21/027

(54) **MICROPATTERN FORMATION MATERIAL AND METHOD OF MICROPATTERN FORMATION**

(30) Priority: 11.06.2003 JP 2003165972
(71) Applicant: AZ Electronic Materials USA Corp., Somerville, NJ 08876 (US)
(72) Inventor: TAKAHASHI, Kiyohisa, c/o Clariant(Japan)K.K., Ogasa-gun, Shizuoka 4371496 (JP); TAKANO, Yusuke, c/o Clariant(Japan)K.K., Ogasa-gun, Shizuoka 4371496 (JP)
(74) Representative: Isenbruck, Günter
(86) International application number: PCT/JP2004/007832
(87) International publication number: WO 2004/111735

(57) **Abstract**

The present invention provides a method of forming a fine pattern, comprising the steps of forming a resist pattern 3 made of a chemically amplified photoresist on a substrate 1 with a diameter of 6 inches or more, applying a fine pattern forming material containing a water-soluble resin, a water-soluble crosslinking agent and water or a mixed solvent of water and a water-soluble organic solvent to form a coated layer 4, baking the chemically amplified photo resist pattern and the coated layer, and developing the coated layer after baking, wherein the water-soluble resin in the fine pattern forming material is a water-soluble resin, the peak temperature of heat of fusion of which in a DSC curve is higher than the baking temperature in the above baking step and simultaneously higher than 130°C.

## Description

### Technical Field

The present invention relates to a method of forming a fine pattern, wherein finer patterns can be formed by reducing the width of a gap between a resist pattern and a resist pattern which are already formed or the size of a pattern opening in forming resist patterns in a process of manufacturing a semiconductor device and so on, as well as a fine pattern forming material used in the method.

### Background Art

In various fields including manufacturing a semiconductor device such as LSI, forming a liquid crystal display face such as LCD panels, and manufacturing circuit substrates for thermal heads and so on, formation of resist patterns on substrates is conducted for formation of fine elements or for fine processing. Formation of these resist patterns employs a photolithographic method which involves light exposure of a photosensitive resin composition by selective irradiation with actinic rays such as ultraviolet rays, deep ultraviolet rays, anexcimerlaser, X-rays or electron beams and subsequent development treatment thereof. In this photolithographic method, a positive-or negative-working photosensitive resin composition is used to form resist patterns.

As semiconduct or devices and so on have been highly integrated in recent years, a line width of a wire and a gap between separated wires required in these manufacturing processes come to be further fine, and in coping therewith, light-exposure devices utilizing a short-wavelength light source such as g-line, i-line, an excimer laser and so on are used, and a phase-shift mask and so on are also used in light exposure. In the conventional photolithographic technology using light exposure, however, formation of fineres ist patterns exceeding the limit of wavelength is difficult and the light-exposure devices for short wavelength and the devices using a phase-shift mask are expensive.

Accordingly, methods wherein resist patterns are formed from a known positive- or negative-working photosensitive resin composition by a known pattern-forming device without using the expensive devices and the formed resist patterns are efficiently made fine have been extensively studied. As one method of making resist patterns fine efficiently, there is proposed a method of forming fine resist patterns below the limit of resolution efficiently as follows. That is, patterns are formed from a known photosensitive resin composition such as a chemically amplified photoresist by a conventional method, a coated layer comprising a fine pattern forming material containing a water-soluble resin is applied onto the formed resist patterns, the resist is heated and/or exposed to permit an acid formed in the resist or an acid present in the resist diffusing into the coated layer, and by this diffused acid, the coated layer is crosslinked and cured. Thereafter the non-crosslinked coated layer is removed to thicken the resist patterns. As a result, the width of a gap between the resist patterns is decreased, the resist patterns are made fine by reducing the separation size of the resist patterns or the size of a hole opening, and the fine resist patterns with the limit of resolution or less are effectively formed (see, for example, JP5-241348A, JP6-250379 A, JP 10-73927 A, and JP 11-204399 A).

At present, fine patterns such as 0.13 µm contact holes can be formed in a resist single layer due to development of ArF resist process, but actual results at a practical level are insufficient under the present circumstances. On the other hand, formation of 0.16 to 0. 18 µm contact holes in a KrF resist single layer is made possible due to growth of KrF resist process. This technology is at a practical level.

As described above, the formation of 0. 13 µm contact holes in a resist single layer at a practical level is difficult in the present condition. Accordingly, it can be anticipated that fine patterns possible to form at a practical level, for example 0.18 µm contact holes are formed and the patternsare made effectively fine by the known method described above. However, there is a problem that when a coated layer comprising a fine pattern forming material is formed on the resist patterns first, then an acid is diffused into the coated layer by heating and so on and non-cured parts are developed with a developing solution according to this method, a large number of development defects are observed after development, which cause the lower product yield. This is a serious problem in a substrate having a large diameter of 6 inches or more. Due to the progress of KrF resist process and so on, highly fine patterns can be formed. However, to make the patterns finer by using the fine pattern forming material, formation of a cured coated film with thin and intended thickness of the fine pattern forming material has come to be more necessary than in the past. However, when a coated layer is formed from the conventional fine pattern forming material by crosslinking and curing at a baking temperature increased to reduce the number of development defects, there occurs the problem that the thickness of the crosslinked and cured film comes to be thicken, thus failing to form a crosslinked and cured thin film with the intended thickness, and thus a pattern with an uniform diameter or gap therebetween cannot be formed.

Accordingly, an object of the present invention is toprovide a method of forming a fine resist pattern, wherein generation of development defects can be reduced, and a cured coated layer formed on a resist pattern can be made always thin in almost predetermined thickness regardless of baking temperature in the method of making a resist pattern effectively finer by using the aforementioned fine pattern forming material, as well as a fine pattern forming material used in this method.

### Disclosure of Invention

As a result of extensive studies and investigations, the present inventors found that in the aforementioned known method of forming a fine pattern, the above-described usual problems can be solved by using a specific water-soluble resin as a water-soluble resin constituting the fine pattern forming material and the present invention was thereby completed.

That is, the present invention relates to a method of forming a fine pattern, comprising the steps of forming a resist pattern made of a chemically amplified photoresist on a substrate with a diameter of 6 inches or more, applying a fine pattern forming material containing a water-soluble resin, a water-soluble crosslinking agent, and water or a mixed solvent of water and a water-soluble organic solvent onto the resist pattern to form acoated layer thereon, baking the chemically amplified photoresist pattern and the coated layer, and developing the coated layer after baking, wherein the water-soluble resin in the fine pattern forming material is a water-soluble resin, the peak temperature of heat of fusion of which in a DSC curve is higher than the baking temperature in the above baking step and simultaneously higher than 130°C.

Further, the present invention relates to a fine pattern forming material comprising a water-soluble resin, a water-soluble crosslinking agent, and water or a mixed solvent of water and a water-soluble organic solvent, which is used in the method of forming a fine pattern as described above, wherein the water-soluble resin is a water-soluble resin, the peak temperature of heat of fusion of which in a DSC curve is higher than the baking temperature in the baking step and simultaneously higher than 130°C.

Further, the present invention relates to the fine pattern forming material described above, wherein the water-soluble resin is a modified polyvinyl alcohol having a polymerization degree of 300 to 1700, protected with a protecting group.

Further, the present invention relates to the fine pattern forming material described above, wherein the water-soluble crosslinking agent comprises at least one member selected from a melamine derivative and a urea derivative.

### Brief Description of Drawing

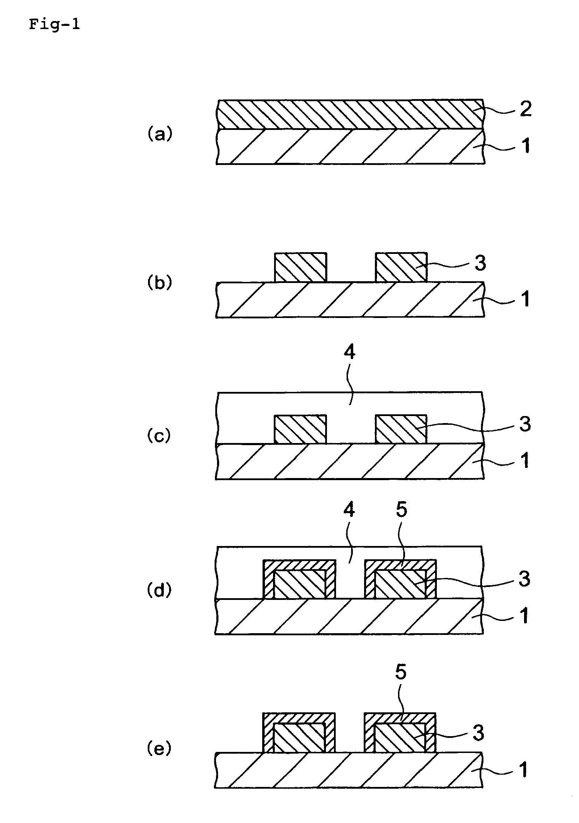

Fig. 1 shows a step of thickening resist patterns using a fine pattern forming material and reducing the size of a gap between resist patterns to make the resist patterns fine.
Explanation for code numbers in Fig-1
1 a substrate; 2 a photoresist layer; 3 a resist pattern; 4 a coated layer by a fine pattern forming material; 5 a developer-insoluble crosslinked or hardened layer

### Description of Invention

Hereinafter, the present invention is described in more detail.

In the method of forming a fine pattern according to the present invention, the conventional problem in the known method of forming a fine pattern is solved by using a water-soluble resin, the peak temperature of heat of fusion of which in a DSC curve is higher than the baking temperature in the baking step and simultaneously higher than 130°C. The reason where by using a water-soluble resin having such characteristics, the problem in the prior art is solved and the effect of the present invention is achieved is estimated as follows, however the present invention is not thereby limited.

That is, as described in the patent applications above, there is known a method of making resist pattern fine, which comprises the steps of applying a fine pattern forming material obtained by dissolving a water-soluble resin and a water-soluble crosslinking agent as major components in water or a mixed solvent of water and a water-soluble or ganicsolvent, onto an acid-supplying resist pattern to form a coated layer thereon; heating and/or light-exposing it to generate an acid from the resist pattern and cause, by the acid, crosslinking reaction in the area of the coated layer contacting with the resist pattern to permit the coated layer to form a cross linked and cured film; and removing non-crosslinked areas with a developing agent to thicken the resist pattern. In this crosslinking reaction, theresist pattern and the coated layer are subjected to heating (baking) so far at a temperature of 85°C to 130°C, and the water-soluble resin (for example polyvinyl acetal) in the fine pattern forming material used at a practical level has a peak temperature of heat of fusion between 85°C and 130°C. Accordingly, the coated layer formed on the acid-supplying resist pattern is in a melted state during the heating. Therefore, the acid is diffused in a broader range than intended, and the crosslinking and curing of the coated layer occur in a broader range than intended, thus the cured coated layer coming to be thickened.

It is thought that when the water-soluble resin having a peak temperature of heat of fusion higher than 130°C, preferably 150°C or more in a DSC curve is used as a water-soluble resin in the fine pattern forming material of the present invention, the coated layer does not melt upon heating for promoting crosslinking reaction, and thus the diffusing distance of the acid supplied from the resist pattern is shorter than when the coated layer is unmolten. Therefore the crosslinking reaction occurs in the range of narrow and almost predetermined thickness. As a result, the thickness of the formed coated layer can be made thin and made a thickness nearly predetermined hardly undergoing the considerable influence of heating temperature.

Further, the present inventors have found that when the water-soluble resin is a modified polyvinyl alcohol, the degree of protection thereof with a protective group such as an acetyl group, acetal group and so on should be lowered in order to allow the peak temperature of heat of fusion of the water-soluble resin in a DSC curve to be kept at a temperature of higher than 130°C. The present inventors have simultaneously found that as compared with the water-soluble resin in the conventional fine pattern forming material used at a practical level, the modified polyvinyl alcohol improves solubility in water when the degree of protection thereof with a protective group such as an acetyl group, acetal group and so on is low. Accordingly, it has been also revealed that when the fine pattern forming material of the present invention is used to form a coated layer on a resist pattern, and by an acid supplied from the resist pattern, crosslinking reaction is caused in the area of the coated layer contacting with the resist pattern to form a crosslinked and cured layer in that area, the solubility of non-crosslinked areas in a developing agent is higher than conventional ones' upon removing the non-crosslinked areas by development with the developing agent consisting of water or a mixed solvent of water and a water-soluble organic solvent-and thereby generation of defects caused by development scumis reduced. It was also revealed that the contrast of the solubility between the crosslinked areas and the non-crosslinked areas in the developing solution is increased, and thereby the shape of the pattern after development is improved.

As the water-soluble resin having a peak temperature of heat of fusion higher than 130°C in a DSC curve, which is used in the fine pattern forming material of the present invention, there are illustrated typically a modified polyvinyl alcohol obtained by modifying 20 mol% or less hydroxyl group of polyvinyl alcohol with a protective group such as an acetyl group, acetal group, formal group, butyral group and so on. The reaction of the hydroxyl group of polyvinyl alcohol for protection with an acetyl group, acetal group, formal group, butyral group and so on can be carried out by known methods described in, for example, JP 10-158328A. The protective group for protecting the hydroxyl group of polyvinyl alcohol may be not only the above-enumerated groups but also a formyl group, malonyl group, benzoyl group, cinnamoyl group, t-butoxycarbonyl group, ethoxyethylene group and so on. The polymerization degree of the modified polyvinyl alcohol is preferably in the range of 300 to 1700. When the polymerization degree of the modified polyvinyl alcohol is less than 300, there is a problem failing to form a film. On the other hand, when the polymerization degree is higher than 1700, developability is deteriorated to cause development defect seasily. The water-soluble resin having a peak temperature of heat of fusion higher than 130°C in a DSC curve includes polyvinyl pyrrolidone, polyacrylic acid derivatives and so on in addition to the modified polyvinyl alcohol.

Further, the fine pattern forming material contains a water-soluble crosslinking agent and a solvent in addition to the above-described water-soluble resin. The water-soluble crosslinking agent may be any one which can crosslink or cure the water-soluble resin and form a developer-insoluble film by anacid. Examples of the water-soluble crosslinking agent include melamine derivatives, urea derivatives and so on as preferable ones.

Among these water-soluble crosslinking agents, as examples of the melamine derivative, there are illustrated melamine, methoxy methylated melamine, methoxy ethylated melamine, propoxy methylated melamine, hexamethylole melamine and so on. As examples of the urea derivative, there are illustrated urea, monomethylol urea, dimethylol urea, alkoxy methylene urea, N-alkoxy methylene urea, ethylene urea and so on. These water-soluble crosslinking agents can be used singly or in a combination of two or more thereof, and the formulating amount thereof is 1 to 70 parts by weight, preferably 5 to 60 parts by weight and more preferably 10 to 30 parts by weight relative to 100 parts by weight of the water-soluble resin.

As a solvent, water or a mixed solution of water and a water-soluble organic solvent is used. As water used as a solvent, there is no particular limit if it is water, however water from which or ganic impurities and metalions are removed by adistillation, an ion exchange treatment, a filter treatment, a various kind of absorption treatment or the like, for example pure water is preferred.

On the other hand, the water-soluble organic solvent may be any solvent capable of being dissolved at 0.1 % by weight or more in water. As the organic solvent which can be used in the present invention, there are illustrated, for example, alcohols such as methylalcohol, ethylalcohol, n-propylalcohol, isopropyl alcohol(IPA) and so on; ketones such as acetone, methyl ethyl ketone and so on; esters such as methyl acetate, ethyl acetate and so on; ethylene glycol monoalkyl ethers such as ethylene glycol monomethyl ether, ethylene glycol monoethyl ether and so on; ethylene glycol monoalkyl ether acetates such as ethylene glycol monomethyl ether acetate, ethylene glycol monoethyl ether acetate and so on; propylene glycol monoalkyl ethers such as propylene glycol monomethyl ether, propylene glycol monoethyl ether and so on; propylene glycol monoalkyl ether acetates such as propylene glycol monomethyl ether acetate, propylene glycol monoethyl ether acetate and so on; lactic esters such as methyl lactate, ethyl lactate and so on; aromatic hydrocarbons such as toluene, xylene and so on; amides such as N,N-dimethyl acetamide, N-methylpyrrolidone and so on; lactones such as γ-butyrolactone and so on; aprotic polar solvents such as N,N-dimethylformamide, dimethylsulfoxide and so on. As preferable organic solvents, there are illustrated C₁₋₄ lower alcohols such as methyl alcohol, ethyl alcohol, n-propyl alcohol, isopropyl alcohol, isobutanol and so on, aprotic polar solvents such as N,N-dimethylformamide, dimethylsulfoxide and so on. These organic solvents can be used singly or in a combination of two or more thereof. When these organic solvents are contained in the fine pattern forming material, and in addition, the material is coated on the resist pattern, they are used at the amount in the range where they do not dissolve the objective resist pattern to be coated.

The fine pattern forming material of the present invention may contain additives such as a surfactant, a leveling agent, a plasticizer and so on, if necessary. The surfactant includes, for example, Acetylenol manufactured by Kawaken Fine Chemical Co., Ltd., Surfinol manufactured by Nisshin Chemicals Co., Ltd., Pionine manufactured by Takemoto Oil & Fat Co., Ltd., Fluorad manufactured by SUMITOMO 3M Limited, Nonipol manufactured by Sanyo Chemical Industries, Ltd. and Megafac manufactured by Dai-Nippon Ink & Chemicals, Inc. The plasticizer includes ethylene glycol, glycerin, triethyl glycol and so on.

Preferably, the fine pattern forming material of the present invention contains the water-soluble resin having a peak temperature of heat of fusion higher than 130°C in a DSC curve in an amount of 1 to 30 parts by weight, preferably 2 to 15 parts by weight and the water-soluble crosslinking agent in an amount of 0.1 to 10 parts by weight, preferably 0 .1 to 5 parts by weight relative to 100 parts by weight of water or a mixed solvent of water and a water-soluble organic solvent.

Formation of a resist pattern in the method of forming a fine pattern according to the present invention may be carried out according to the methods known in the art. An example thereof will be explained by referring to Fig. 1 (a) and (b). First as shown in Fig. 1(a), a chemically amplified radiation sensitive resin composition is applied on a substrate to be processed, for example a semiconductor substrate 1 and pre-bake is carried out, if necessary, for example, at a baking temperature of 70 to 150°C for about one minute to form a photoresist layer 2. Next, after exposing to light through a photo-mask which is not illustrated in the figure, the photoresist layer is post-exposure baked (PEB), if necessary, for example, at a baking temperature of 50 to 150°C, developed, and post-development baked, if necessary, for example, at a baking temperature of 60 to 120°C, to form a positive resist pattern 3 as shown in Fig. 1 (b).

The semiconductor substrate 1 to be used for forming a resist pattern described above may beabare semiconductor substrate or a substrate of a silicon or the like having a silicon oxide layer, a metal layer such as aluminum, molybdenum, chromium and so on, a metal oxide layer such as ITO and so on, and a silicon layer such as polysilicon on the surface thereof, if necessary and further a substrate on which a circuit pattern or a semiconductor element is formed. The application of a chemically amplified radiation sensitive resin composition is made according to the methods so far publicly known such as a spin coating method, a roll coating method, a land coating method, a flowing and spreading coating method, a dip coating method and so on. Examples of light-exposure sources to be used include deep ultraviolet rays such as a KrF excimer laser and an ArF excimer laser, X-rays, electron beams and so on. Further, a developer for a photoresist film may be any one which can develop a chemically amplified radiation sensitive resin composition to be applied, and usually an alkali aqueous solution of tetramethyl ammonium hydroxide, sodium hydroxide or the like is used. A development method may be any one so far applied for a development of a photoresist such as a paddle method or a spray method.

Next, the method will be explained by referring to Fig. 1 (c) to (e), wherein a coated layer which is crosslinked with an acid is formed on the resist pattern obtained as described above and thereby the gap between a resist pattern and a resist pattern is narrowed to form a pattern having a width below a limit resolution of a light-exposure wavelength. That is, as shown in Fig. 1 (c), the fine pattern forming material of the present invention is applied on a resist pattern 3 first, and baked, if necessary, for example, at a baking temperature of 65 to 85°C for about one minute to form a coated layer 4. Next, a bake is carried out, for example, at a baking temperature of 90 to 130°C for about one minute in order to diffuse acids from the resist pattern 3 into the coated layer 4. Thereby acids are diffused from the resist pattern 3 to form a crosslinked and cured layer 5 in the coated layer 4 as shown in Fig. 1 (d). The coated layer 4 is developed with a developer for an exclusive use, the coated layer which is neither crosslinked nor cured is removed to form a pattern which is thickened by the crosslinked and cured layer 5 as shown by Fig. 1 (e), and eventually the gap between a resist pattern and a resist pattern is narrowed to form a finer pattern. The formed finer pattern is used as a resist mask for a fine processing of a substrate or resist mask for treatment such as an etching mask, an ion implantation mask and so on.

In making a resist pattern fine by the fine pattern forming material known in the art, development defects easily occur particularly on a substrate having a large diameter of 6 inches or more. Accordingly, particularly preferable results can be obtained when a substrate of 6 inches or more in diameter is used as the substrate in the method of the present invention.

### Best Mode for Carrying Out the Invention

Hereinafter, the present invention will be described in more detail by reference to the Examples, but the present invention is not limited by the Examples below.

Prior to description of the Examples, synthesis and preparation examples of the water-solubleres inused in the Examples and Comparative examples are described.

### Synthesis Example 1

### (Preparation of water-soluble resin)

A polyvinyl alcohol (manufactured by Nippon Synthetic Chemical Industry Co., Ltd.) having a saponification degree of 88% and a polymerization degree of 500 was introduced into pure water and then dissolved under heating at a temperature of 95°C. After that, the amount of pure water was regulated such that the solids content was 10%, to give an aqueous solution of polymer A (degree of acetylation: 12 mol%).

### (Measurement of melting point)

100 g of aqueous solution of polymer A was poured into acetone (1L) stirredat high speed to precipitate polymer component A. The precipitated polymer component A was collected by filtration and washed with acetone. The sample was dried at room temperature and then absolutely-dried in an oven at 40°C to prepare a sample for melting-point measurement. Then, the temperature of the sample was increased from a temperature of 30°C to 250°C at a rate of 10°C/minute to determine the melting point with a differential scanning calorimeter. The result is shown in Table 1.

### Synthesis Example 2

A polyvinyl alcohol having a saponification degree of 88% and a polymerization degree of 500 was introduced into pure water and then dissolved under heating at a temperature of 95°C to give an aqueous polyvinyl alcohol solution. After that, the polyvinyl alcohol was reacted with acetaldehyde in the presence of a hydrochloric acid catalyst to convert it into an acetal derivative. The resultant solution was then neutralized with an aqueous solution of sodium hydroxide to prepare a solution of a polyvinyl acetal having an acetalization degree of 20 mol%. The amount of pure water was regulated such that the solids content was 10%, to give an aqueous solution of polymer B (degree of acetylation, 12 mol%; degree of acetalization, 20 mol%). The melting point of the polymer B was measured in the same manner as in Synthesis Example 1. The result is shown in Table 1.

### Synthesis Example 3

A polyvinyl alcohol having a saponification degree of 88% and a polymerization degree of 500 was poured into pure water and then heat-treated at a temperature of 95°C to prepare an aqueous polyvinyl alcohol solution. After that, the polyvinyl alcohol solution was heat-treated in the presence of sodium hydroxide, to prepare a polyvinyl alcohol having a saponification degree of 99%. Thereafter, the product was reacted with acetaldehyde in the presence of hydrochloric acid to convert it into an acetal derivative. The resultant solution was then neutralized with an aqueous solution of sodium hydroxide to prepare a solution of a polyvinyl acetal having an acetalization degree of 20 mol%. The amount of pure water was regulated such that the solids content was 10%, to give an aqueous solution of polymer C (degree of acetylation, 1 mol%; degree of acetalization, 20 mol%). The melting point of the polymer C was measured in the same manner as in Synthesis Example 1. The result is shown in Table 1.

**Table 1**

| | Polymer | Degree of acetylation (mol%) | Degree of acetalization (mol%) | Peak temperature of heat of fusion (°C) |
|---|---|---|---|---|
| Synthesis Example 1 | A | 12 | 0 | 200-205 |
| Synthesis Example 2 | B | 12 | 20 | 85-90 |
| Synthesis Example 3 | C | 1 | 20 | 125-130 |

As can be seen from Table 1, the melting point is increased as the amount of the protective group introduced into the hydroxyl group of the polyvinyl alcohol is decreased.

### Example 1

### (Preparation of fine pattern forming material)

2 parts by weight of a water-soluble urea derivative crosslinking agent, 7 parts by weight of isopropyl alcohol as a water-soluble organic solvent and 50 parts by weight of pure water were mixed with and dissolved in 100 parts by weight of the aqueous solution of polymer A prepared in Synthesis Example 1, where by a fine pattern forming material A (referred to here in after as "Material A") was prepared.

Then, Material A was subjected to the following "Inspection for film thickness of the coated layer" and "Defect inspection after development".

### [Inspection for film thickness of the coated layer]

AZ KrF-17B 80 (manufactured by Clariant Co. AZ is a registered trademark, the followings are same.) was spin coated on a 6-inch bare silicon wafer, followed by baking it at 180°C for 60 seconds on a direct hot plate to prepare an anti-reflective coating of 0.080 µm in thickness. Further AZ DX5240P (manufactured by Clariant Co.) was spin-coated thereon, followed by baking at 90°C for 60 seconds on a direct hot plate to form a chemically amplifiable positive-working photoresist film of 0.585 µm in thickness. This resist film was exposed to light selectively through a halftone mask by a KrF excimer laser of 248.4 nm in wave length, followed by carrying out a post-exposure baking (PEB) at 120°C for 60 seconds on a direct hot plate. Then puddle-development was carried out using AZ 300MIF manufactured by Clariant Co. (2.38 weight-% tetramethyl ammonium hydroxide aqueous solution) as a developing solution for 60 seconds to form a hole pattern having a diameter of 0.220 µm on the silicon wafer. Material A was spin-coated on this hole pattern and baked on a direct hot plate at 85°C for 70 seconds to form a film of 0.350 µm in thickness. Then, after conducting a bake (mixing bake) on a direct hot plate for 70 seconds at 105, 110, 115, 120, 125 and 130°C respectively to promote crosslinking reaction of the interface between the resist layer and Material A, and then developed with pure water by a running water method for 60 seconds to form a coated layer thereon. Using CD-SEM (S9220 manufactured by Hitachi High-Technologies Corporation), the diameter of the hole pattern after formation of the coated layer was measured, and the difference of the measured diameter from the diameter of the initial hole was regarded as the thickness of the coated layer. The result is shown in Table 2.

### [Defects inspection after development]

AZKrF-17B80 (manufactured by Clariant Co.) was spin-coated on a bare 6-inch silicon wafer, followed by baking it at 180°C for 60 seconds on a direct hotplate to prepare an anti-reflective coatingof 0.080 µm in thickness. Further AZ DX5240P manufactured by Clariant Co. was spin-coated thereon, followed by pre-baking it at 90°C for 60 seconds on a direct hotplate to form a resist film of 0.585 µm in thickness. The resist film was exposed to light through a binary mask selectively by KrF excimer laser of 248.4 nm in wavelength, followed by carrying out a post exposure bake (PEB) at 120°C for 60 seconds on a direct hotplate, and paddle-developing using AZ 300MIF manufactured by Clariant Co. (a 2.38 weight-% tetramethylammonium hydroxide aqueous solution) as a developing solution for 60 seconds to form a hole pattern having a diameter of 0.250 µm on the silicon wafer. Material A was spin-coated on this hole pattern and baked at 85°C for 70 seconds on a direct hotplate to form a film of 0.350 µm in thickness. Next, after conducting a bake (mixing bake) on a direct hotplate at 105, 110, 115, 120, 125 and 130°C, respectively for 70 seconds in order to promote a crosslinking reaction at the interface between the resist layer and Material A, a running water development with pure water was carried out for 60 seconds to form a coated layer. By using a surface defects inspector KLA-2115 manufactured by KLA-Tencor Co., a measurement of defects inspection after development was carried out. An evaluation of defect number after development was made by regarding as a defect after development in the case where a pattern was not developed completely and a bridge was formed over a hole pattern, and regarding the number of the total defects on a wafer as the number of defects after development. The result was shown in Table 3.

### Comparative Example 1

The same manner was taken as Example 1 except applying the polymer B obtained in Synthesis Example 2 instead of the polymer A to prepare a fine pattern forming material B (hereinafter it is called Material B). In the same manner as Example 1, "Inspection for film thickness of the coated layer" and "Defect inspection after development" of Material B were carried out. The results were shown in Tables 2 and 3.

### Comparative Example 2

The same manner was taken as Example 1 except applying the polymer C obtained in Synthesis Example 3 instead of the polymer A to prepare a fine pattern forming material C (hereinafter it is called Material C). In the same manner as Example 1, "Inspection for film thickness of the coated layer" and "Defect inspection after development" of Material C were carried out. The results were shown in Tables 2 and 3.

### Comparative Example 3

1.5 parts by weight of a water-soluble urea derivative crosslinking agent, 7 parts by weight of isopropyl alcohol as a water-soluble organic solvent and 50 parts by weight of pure water were mixed with and dissolved in 100 parts by weight of the polymer B, whereby a fine pattern forming material D (referred to hereinafter as "Material D") was prepared. Material D was subjected to "Inspection for film thickness of the coated layer" and "Defect inspection after development" in the same manner as in Example 1. The results are shown in Tables 2 and 3, respectively.

**Table 2-1. Inspection of the amount of a coating formed**

| Mixing bake temperature (°C) | Example 1 | | Comparative Example 1 | |
|---|---|---|---|---|
| | Hole size (µm) | Amount of coating formed (µm) | Hole size (µm) | Amount of coating formed (µm) |
| Composition | A | | B | |
| Initial | 0.220 | - | 0.220 | - |
| 105 | 0.174 | 0.046 | 0.155 | 0.065 |
| 110 | 0.173 | 0.047 | 0.151 | 0.069 |
| 115 | 0.172 | 0.048 | 0.146 | 0.074 |
| 120 | 0.171 | 0.049 | 0.128 | 0.092 |
| 125 | 0.171 | 0.049 | - | - |
| 130 | 0.170 | 0.050 | - | - |

**Table 2-2. Inspection of the amount of a coating formed**

| Mixing bake temperature (°C) | Comparative Example 2 | | Comparative Example 3 | |
|---|---|---|---|---|
| | Hole size (µm) | Amount of coating formed (µm) | Hole size (µm) | Amount of coating formed (µm) |
| Composition | C | | D | |
| Initial | 0.221 | - | 0.220 | - |
| 105 | 0.172 | 0.049 | 0.170 | 0.050 |
| 110 | 0.170 | 0.051 | 0.165 | 0.055 |
| 115 | 0.168 | 0.053 | 0.159 | 0.061 |
| 120 | 0.167 | 0.054 | 0.143 | 0.077 |
| 125 | 0.164 | 0.057 | - | - |
| 130 | 0.160 | 0.061 | - | - |

In the tables, "_" in the column of hole size indicates that the hole size could not be measured because the amount of the coating formed was too much, thus causing a large number of development defects to crush contact holes.

It can be seen from Table 2 that the amount of the coating formed from Material A using a water-soluble resin having a peak temperature of heat of fusion higher than 130°C in a DSC curve is as low as 0.050 µm even at a mixing bake temperature of 130°C. In addition, the difference in the amount of the coating due to a difference in baking temperature is also small. It can also be seen that the mixing bake temperature should be lowered or the amount of the water-soluble crosslinking agent should be reduced in order that the amount of the coating formed from Material B, C or D using a water-soluble resin having a peak temperature of heat of fusion at 130°C or less is 0.050 µm.

**Table 3. Defect inspection after development**

| Mixing bake temperature (°C) | Number of defects (number/wafer) | | | |
|---|---|---|---|---|
| | Example 1 | Comparative Example 1 | Comparative Example 2 | Comparative Example 3 |
| 105 | 253 | 415 | 288 | 520 |
| 110 | 180 | 292 | 296 | 405 |
| 115 | 143 | 198 | 181 | 243 |
| 120 | 56 | 94 | 90 | 117 |
| 125 | 39 | 78 | 81 | 89 |
| 130 | 21 | - | 59 | - |

In the table, "_" indicates that the number of defects could not be measured because the amount of the coating formed was too much, thus causing a large number of development defects to crush contact holes.

As can be seen from Table 3, the number of defects after development tends to be decreased by increasing the mixing bake temperature. In the results in Tables 2, however, the thickness of the coated layer made of Material B, C or D is increased when the mixing bake temperature is increased, thus making the hole pattern smaller than the target size. It can be seen that Material A prepared in Example 1 by using a water-soluble resin having a peak temperature of heat of fusion higher than 130°C in a DSC curve has such extremely excellent properties that the amount of the coating formed therefrom is not changed even if the mixing bake temperature is increased, while the number of defects after development is reduced.

### Effect of the Invention

According to the present invention as described in detail above, a crosslinked or cured coated layer with which a resist pattern is coated can be made thin even if the baking temperature is high, and a unevenness, due to a difference in baking temperature, in the thickness of the crosslinked or cured coating can be reduced with regardless of the baking temperature, the coating film can be thin in a predetermined range to form a fine pattern with a reduction in development defects. In fine processing for production of electronic parts such as semiconductors and three-dimensional fine structures, a pattern with a size of the limit resolution of exposure-light wavelength or less can thereby be formed with high accuracy and high through-put as designed by a design rule.

### Industrial Applicability

The fine pattern forming material of the present invention is used as an auxiliary agent for forming a finer pattern in forming a resist pattern in a process of manufacturing semiconductors or the like.

## Claims

1. A method of forming a fine pattern, comprising steps of forming a resist pattern made of a chemically amplified photoresist on a substrate with a diameter of 6 inches or more, coating the pattern with a fine pattern forming material containing a water-soluble resin, a water-soluble crosslink ingagent and water or a mixed solvent of water and a water-soluble organic solvent to form a coated layer, baking the chemically amplified photoresist pattern and the coated layer, and developing the coated layer after baking, wherein the water-soluble resin in the fine pattern forming material is a water-soluble resin, the peak temperature of heat of fusion of which in a DSC curve is higher than the baking temperature in the above baking step and simultaneously higher than 130°C.

2. A fine pattern forming material comprising a water-soluble resin, a water-soluble crosslinking agent and water or a mixed solvent of water and a water-soluble organic solvent, which is used in the method of forming a fine pattern as described in claim 1, wherein the water-soluble resin is a water-soluble resin, the peak temperature of heat of fusion of which in a DSC curve is higher than the baking temperature in the baking step and simultaneously higher than 130°C.

3. The fine pattern forming material according to claim 2, wherein the water-soluble resin is a modified polyvinyl alcohol having a polymerization degree of 300 to 1700, which is protected with a protecting group.

4. The fine pattern forming material according to claim 2 or 3, wherein the water-soluble crosslinking agent comprises at least one member selected from a melamine derivative and a urea derivative.
